# EUROPÄISCHE PATENTSCHRIFT

(11) **EP 2 449 388 B1**
(45) Veröffentlichungstag und Bekanntmachung des Hinweises auf die Patenterteilung: **01.01.2014**
(21) Anmeldenummer: 10723133.4
(22) Anmeldetag: 11.06.2010
(51) Int. Cl.: G01R 31/02, G01R 31/00

(54) **VERFAHREN ZUM PRÜFEN EINER KABELVERBINDUNG**
METHOD FOR TESTING A CABLE CONNECTION
PROCÉDÉ POUR TESTER UNE LIAISON PAR CÂBLE

(30) Priorität: 30.06.2009 DE 102009031572
(43) Veröffentlichungstag der Anmeldung: 09.05.2012
(73) Patentinhaber: Siemens Aktiengesellschaft, 80333 München (DE)
(72) Erfinder: KREBS, Uwe, 96114 Hirschaid (DE); MOSER, Jürgen, 91369 Wiesenthau (DE)
(86) Internationale Anmeldenummer: PCT/EP2010/058245
(87) Internationale Veröffentlichungsnummer: WO 2011/000683

(56) Entgegenhaltungen:
- EP-A1- 0 013 860
- JP-A- 3 102 268
- US-A- 4 254 374
- US-A1- 2004 145 374
- US-B1- 6 724 589

## Beschreibung

Die Erfindung betrifft Verfahren zum Prüfen einer Kabelverbindung, die sich zwischen einem mittels eines Anschlussschalters mit der Kabelverbindung verbindbaren Verteilungsnetz eines im Hafen liegenden Schiffes und einem landseitig angeordneten Frequenzumrichter eines elektrischen Versorgungsanschlusses erstreckt, bei dem die Spannung, mit welcher die Kabelverbindung bei unterbrochenem Anschlussschalter beaufschlagt wird, mittels des Frequenzumrichter fortschreitend bis zum Erreichen eines Spannungsschwellenwertes erhöht, der dabei auftretende Stromfluss unter Gewinnung von Strommesswerten erfasst und auf das Vorliegen eines vorgegebenen Kurzschlusskriteriums hin überwacht wird.

Ein solches Verfahren zum Prüfen von Kabelverbindungen ist aus dem Stand der Technik bereits bekannt. So ist beispielsweise in der DE 1 640 254 ein Verfahren beschrieben, mit dem ein Kabel auf seine Isolationsfestigkeit hin überprüft wird. Insbesondere bei Polymerkabeln kommt es häufig zu Einschlüssen eines Holraums oder eines Fremdobjekts in der Isolierung. Aufgrund der anliegenden hohen elektrischen Spannung wird ein in einem Hohlraum eingeschlossenes Gas, wie Luft, isoliert und einem Ionenbeschuss ausgesetzt. Dieser Ionenbeschuss führt häufig zu Isolationsschäden, so dass eine Prüfung durchgeführt werden muss, um solche Fehler ausfindig zu machen. Hierbei wird in der Regel eine hohe Prüfspannung an das Kabel angelegt, welche das Doppelte der Netzspannung weit übertrifft.

Weitere ähnliche Verfahren sind beispielsweise aus der EP 0 013 860 A1 oder US 6,724,589 B1 bekannt.

Bei einem Landanschluss für Schiffe wird ein im Hafen liegendes Schiff über eine Kabelverbindung elektrisch mit einem Versorgungsanschluss verbunden, der an Land angeordnet ist. Zu der Kabelverbindung gehören landseitige Kabel- und Streckenverbindungen sowie schiffsseitige Kabel- und Streckenverbindungen. Auf See sind die Bestandteile der Kabelsteckverbindung rauen Wetterbedingungen ausgesetzt, so dass diese leicht Schaden nehmen können. Entsprechendes gilt für die landseitigen Komponenten des Anschlusses, insbesondere dann wenn diese eine Zeit lang nicht benutzt worden sind. Aus diesem Grund muss die gesamte Kabelverbindung sehr häufig auf Isolationsfehler hin überprüft werden. Auf diese Weise können Materialfehler in der Kabelverbindung erkannt werden, bevor Personen oder anderes Material geschädigt werden kann.

Aufgabe der Erfindung ist es daher, ein Verfahren der eingangs genannten Art bereitzustellen, das häufig wiederholt werden kann und im Fehlerfall die in der unmittelbaren Umgebung befindlichen Personen nicht verletzt.

Die Erfindung löst diese Aufgabe dadurch, dass mittels des Frequenzumrichters ein Kurzschlussstromschwellenwert vorgegeben wird, wobei das Kurzschlusskriterium erfüllt ist, wenn die Strommesswerte gleich dem Kurzschlussstromschwellenwert sind.

Die Erfindung beruht auf der Idee, dass der Frequenzumrichter, der in der Regel zwei gleichspannungsseitig miteinander verbundene Umrichter aufweist, als kurzschlussfeste regelbare Spannungsquelle mit Strommaximalwert betrieben werden kann. Bei intakter Kabelverbindung wird beim Messen des Stromflusses über die Kabelverbindung nur der Ladestrom der Streukapazität der Kabelverbindung zu messen sein. Bei fehlerhafter Kabelverbindung wird hingegen der Strom bis zu dem am Frequenzumrichter eingestellten Kurzschlussstromschwellenwert ansteigen. Ein höherer Anstieg des Kurzschlussstromes erfolgt jedoch nicht. Mit anderen Worten ist der Kurzschlussstrom auf einen Maximalwert begrenzt, wobei der Maximalwert so vorgegeben wird, dass bei auftretendem Fehler Schädigungen von Personen oder Dingen, die sich in unmittelbarer Umgebung der Kabelverbindung befinden, trotz der Prüfung vermieden sind. Aufgrund dieser Strombegrenzung ist somit ein sicheres Verfahren zur Prüfung der Kabelverbindung bereitgestellt, das darüber hinaus die Kabelverbindung wenig belastet.

Weitere Vorteile ergeben sich, wenn der Kurzschlussstromschwellenwert kleiner ist als die bei Normalbetrieb des Versorgungsanschlusses vorliegenden Nennstromwerte. Selbstverständlich ist auch bei dieser vorteilhaften Ausgestaltung der Erfindung der vorgegebene Kurzschlussstromschwellenwert größer als die Messwerte, die dem Ladestrom der Streukapazität der Kabelverbindung entsprechen. Erreichen die Strommesswerte den Kurzschlussstromschwellenwert, kann nicht mehr von einer isolationsfesten Kabelverbindung ausgegangen werden. Das Kurzschlusskriterium ist erfüllt. Anschließend müssen dann weitere Maßnahmen, beispielsweise der Austausch von Kabelteilen oder dergleichen, durchgeführt werden. Der Kurzschlussstromschwellenwert ist gemäß dieser zweckmäßigen Ausgestaltung so gering, dass die Prüfung beliebig oft ohne Kabelbelastung und gleichzeitig sicherer durchgeführt werden kann.

Weitere Vorteile ergeben sich, wenn der Spannungsschwellenwert kleiner ist als die um 10% erhöhte Nennspannung, die bei Normalbetrieb des Versorgungsanschlusses an der Kabelverbindung anliegt.

Gemäß dieser vorteilhaften Weiterentwicklung wird auch die Spannung auf einen kleineren Schwellenwert begrenzt, als dies bei bekannten Isolationsprüfungen von Kabelverbindungen üblich ist. Gemäß dem Stand der Technik beträgt die an die Kabelverbindung angelegte Spannung in etwa das zweieinhalbfache der bei Normalbetrieb herrschenden Spannung. Erfindungsgemäß übersteigt die bei der Prüfung erzeugte Spannung an der Kabelverbindung, die Nennspannung lediglich maximal um 10%. Auf diese Weise ist die Sicherheit der Kabelverbindungsprüfung noch weiter erhöht.

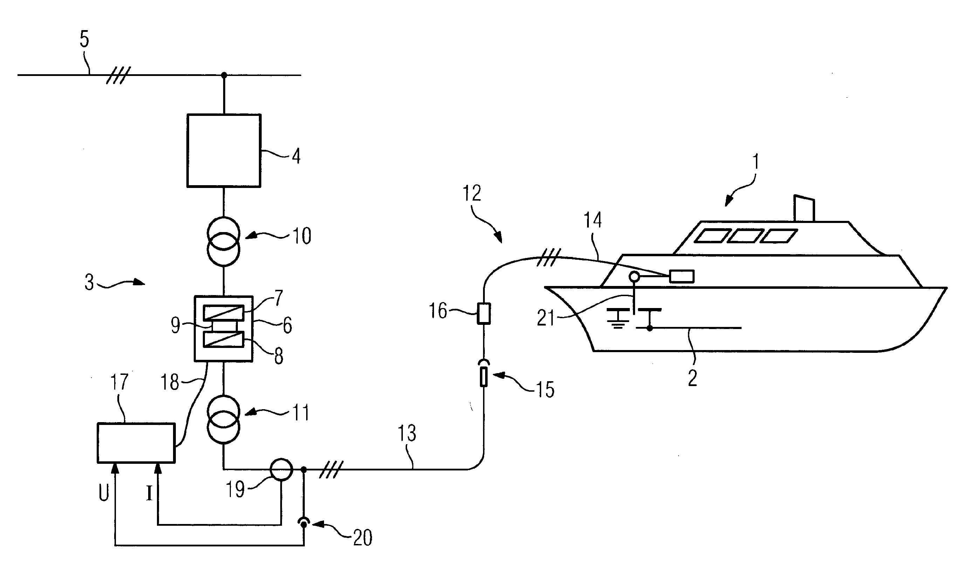

Weitere Merkmale und Vorteile der Erfindung sind Gegenstand der nachfolgenden Beschreibung von Ausführungsbeispielen der Erfindung unter Bezug auf die Figur der Zeichnung, wobei die
- Figur: ein in einem Hafen liegendes Schiff zeigt, das mittels eines Landanschlusses und einer Kabelverbindung mit Energie versorgt wird.

Die Figur zeigt ein Schiff 1, das in einem figürlich nicht dargestellten Hafen anliegt. Zur Energieversorgung des Schiffsverteilungsnetzes 2 des Schiffes 1 dient ein Landversorgungsanschluss 3, der an Land angeordnet ist. Der Landversorgungsanschluss 3 verfügt über eine Schaltanlage 4 mit Leistungsschaltern zum Abtrennen und Ankoppeln eines Energieversorgungsnetzes 5. Der Landanschluss 3 weist ferner einen Frequenzumrichter 6 auf, der einen Gleichrichter 7 sowie einen Wechselrichter 8 umfasst, die durch einen Gleichspannungszwischenkreis 9 miteinander verbunden sind. Dabei ist der Gleichrichter 7 über einen Eingangstransformator 10 mit der Schaltanlage 4 verbunden, während der Wechselrichter 8 über einen Ausgangstransformator 11 und einer Kabelverbindung 12 mit dem Schiffsverteilungsnetz 2 gekoppelt ist. In der Figur sind die elektronischen Bauteile aus Übersichtsgründen nur einphasig dargestellt. Das Energieversorgungsnetz 5, die Kabelverbindung 12, das Schiffsverteilungsnetz 2 und die dazugehörigen Bauteile sind jedoch alle mehrphasig, insbesondere dreiphasig, ausgestaltet.

Es ist erkennbar, dass die Kabelverbindung 12 aus einem landseitigen Hochspannungskabel 13 sowie einem schiffsseitigem Hochspannungskabel 14 zusammengesetzt ist, die über eine Steckverbindung 15 miteinander verbindbar sind. Das schiffsseitige Verbindungskabel 14 ist mit schematisch angedeuteten Sicherungsbauteilen 16 versehen, auf die an dieser Stelle jedoch nicht eingegangen zu werden braucht.

Zur Steuerung des Frequenzumrichters 6 dient eine Regelungseinheit 17, welche über ein Signalkabel 18 mit dem Frequenzumrichter 6, und zwar sowohl mit dem Gleichrichter 7 als auch mit dem Wechselrichter 8 verbunden ist.

Eingangsseitig ist die Regeleinheit 17 mit einem Stromsensor 19 sowie mit einem Spannungssensor 20 verbunden.

Wie bereits weiter oben ausgeführt wurde, ist die Kabelverbindung 12, und zwar sowohl das seeseitige Kabel 14 als auch das landseitige Kabel 13, extremen Witterungsbedingungen ausgesetzt. Aus diesem Grunde muss die Kabelverbindung 12 fortwährend auf ihre Funktionstüchtigkeit, also ihr Isolationsvermögen hin zu untersucht werden. Aus diesem Grunde führt die Regelungseinheit 17 selbsttätig eine Prüfung der Kabelverbindung 12 durch, und zwar beispielsweise dann, wenn die Steckverbindung 15 zusammengesteckt wird. Hierzu umfasst die Kabelverbindung 12 eine figürlich nicht dargestellte Signalleitung, die auf der einen Seite mit der Steckverbindung 15 und auf der anderen Seite mit der Regelungseinheit 17 verbunden ist. Wird die Steckverbindung 15 zusammengeführt, befindet sich ein Anschlussschalter 21 des Schiffsverteilungsnetzes 2 in seiner Unterbrecherstellung. Der lastseitige Widerstand ist daher nahezu unendlich groß, so dass nach Anlegen einer Spannung an die Kabelverbindung 12 lediglich die Ströme zum Aufladen der Streukapazität der Kabelverbindung 12 fließen. Die Regeleinheit 17 regelt den Wechselrichter 8 so, dass dieser einen maximalen Strom in die Kabelverbindung 12 einspeist, der einem Kurzschlussstromschwellenwert entspricht. Der Kurzschlussstromschwellenwert ist höher als die Messwerte des Streukapazitätenladestroms, jedoch deutlich geringer ist als die Messwerte des Nennstroms, der bei üblichen Betriebsbedingungen, also im Kurzschluss freien Betrieb des Schiffsverteilungsnetzes 2, über die Kabelverbindung 12 fließt.

Nach Zusammenfügen der Kabelverbindung 15 regelt die Regelungseinheit 17 durch entsprechende Steuersignale den Wechselrichter 18 so, dass dieser die an der Kabelverbindung 12 abfallende Spannung rampenförmig, also allmählich, steigert, bis ein Spannungsschwellenwert erreicht ist, der in dem gezeigten Ausführungsbeispiel 10% oberhalb der Nennspannung liegt. Mit anderen Worten ist die am Ende der Prüfung mittels des Frequenzumrichters in der Kabelverbindung angelegte Spannung maximal 10% höher als die Nennspannung. Gleichzeitig ist der maximale Stromfluss auf einen Wert weit unterhalb des Nennstromes begrenzt. Die bei der Prüfung der Kabelverbindung 12 auftretende Gefahr ist somit gering.

Gemäß der Erfindung werden somit die Bestandteile der Kabelverbindung 12 während der Prüfung nur wenig belastet. Darüber hinaus werden Personen, die sich in der unmittelbaren Umgebung der Kabelverbindung 12 befinden, keiner großen Gefahrenquelle ausgesetzt. Die Prüfung kann daher beliebig oft wiederholt werden, ohne dass weitergehende Maßnahmen, wie beispielsweise Evakuierung der Personen in der unmittelbaren Kabelumgebung oder dergleichen, erforderlich sind.

## Patentansprüche

1. Verfahren zum Prüfen einer Kabelverbindung (12), die sich zwischen einem mittels eines Anschlussschalters (21) mit der Kabelverbindung (12) verbindbaren Verteilungsnetz (2) eines im Hafen liegenden Schiffes (1) und einem landseitig angeordneten, als Spannungsquelle mit Strommaximalwert betriebenem Frequenzumrichter (6) eines elektrischen Versorgungsanschlusses (3) erstreckt, bei dem die Spannung (U), mit welcher die Kabelverbindung (12) bei unterbrochenem Anschlussschalter (21) beaufschlagt wird, mittels des Frequenzumrichters (6) fortschreitend bis zum Erreichen eines Spannungsschwellenwertes erhöht, der dabei auftretende Stromfluss unter Gewinnung von Strommesswerten erfasst und auf das Vorliegen eines vorgegebenen Kurzschlusskriteriums hin überwacht wird,
**dadurch gekennzeichnet, dass**
mittels des Frequenzumrichters (6) ein Kurzschlussstromschwellenwert vorgegeben wird, wobei das Kurzschlusskriterium erfüllt ist, wenn die Strommesswerte gleich dem Kurzschlussstromschwellenwert sind.

2. Verfahren nach Anspruch 1,
**dadurch gekennzeichnet, dass**
der Kurzschlussstromschwellenwert kleiner ist als die bei Normalbetrieb des Versorgungsanschlusses (3) vorliegende Nennstromwerte.

3. Verfahren nach Anspruch 1 oder 2,
**dadurch gekennzeichnet, dass**
der Spannungsschwellenwert kleiner ist als die um 10% erhöhten bei Normalbetrieb des Versorgungsanschlusses (3) vorliegenden Nennspannungswerte.

## Claims

1. Method for testing a cable connection (12), which extends between a distribution system (2), which can be connected to the cable connection (12) by means of a connecting switch (21), of a marine vessel (1), which is lying in a harbor, and a frequency converter (6), which is arranged on the land side and is operated as a voltage source with a maximum current value, of an electrical supply connection (3), in which the voltage (U) which is applied to the cable connection (12) when the connecting switch (21) is interrupted is continually increased by means of the frequency converter (6) until a voltage threshold value is reached, the current flow which occurs in this case is recorded, with current measured values being obtained, and monitoring is carried out for the presence of a predetermined short-circuit criterion,
**characterized in that**
a short-circuit current threshold value is predetermined by means of the frequency converter (6), with the short-circuit criterion being satisfied when the current measured values are equal to the short-circuit current threshold value.

2. Method as claimed in Claim 1,
**characterized in that**
the short-circuit current threshold value is lower than the rated current values which occur during normal operation of the supply connection (3).

3. Method as claimed in Claim 1 or 2,
**characterized in that**
the voltage threshold value is lower than the rated voltage values, increased by 10%, which are present during normal operation of the supply connection (3).

## Revendications

1. Procédé de contrôle d'une liaison ( 12 ) par câble, qui s'étend entre un réseau ( 2 ) de distribution, pouvant être relié à la liaison ( 12 ) par câble au moyen d'un commutateur ( 21 ) de raccordement, d'un bateau ( 1 ) au port et un convertisseur ( 6 ) de fréquence, disposé du côté de la terre et fonctionnant comme source de tension à valeur maximum de courant, d'une borne ( 3 ) d'alimentation électrique, dans lequel la tension ( U ), appliquée à la liaison ( 12 ) par câble lorsque le commutateur ( 21 ) de raccordement est interrompu, est augmentée au moyen du convertisseur ( 6 ) de fréquence progressivement jusqu'à atteindre une valeur de seuil de tension, le flux de courant ainsi produit est détecté en obtenant des valeurs de mesure du courant et on en contrôle la présence d'un critère prescrit de court-circuit,
**caractérisé en ce que**
on prescrit une valeur de seuil de courant de court-circuit au moyen du convertisseur ( 6 ) de fréquence, le critère de court-circuit étant satisfait si les valeurs de mesure du courant sont égales à la valeur de seuil du courant de court-circuit.

2. Procédé suivant la revendication 1,
**caractérisé en ce que**
la valeur de seuil de courant de court-circuit est plus petite que les valeurs de courant nominal présentes en fonctionnement normal de la borne ( 3 ) d'alimentation.

3. Procédé suivant la revendication 1 ou 2,
**caractérisé en ce que**
la valeur de seuil de tension est plus petite que les valeurs de tension nominal présentes en fonctionnement normal de la borne ( 3 ) d'alimentation augmentées de 10%.
